# EUROPEAN PATENT APPLICATION

(11) **EP 4 633 318 A1**
(43) Date of publication of application: **15.10.2025**
(21) Application number: 24216669.2
(22) Date of filing: 29.11.2024
(51) Int. Cl.: H10B 43/40, H10D 89/10, H10D 84/01, H10D 62/10

(54) **THREE-DIMENSIONAL SEMICONDUCTOR MEMORY DEVICE AND ELECTRONIC SYSTEM INCLUDING THE SAME**

(30) Priority: 09.04.2024 KR 20240047997
(71) Applicant: Samsung Electronics Co., Ltd., Suwon-si, Gyeonggi-do 16677 (KR)
(72) Inventor: LEE, Sea Hoon, 16677 Suwon-si (KR); LIM, Junhee, 16677 Suwon-si (KR)
(74) Representative: Marks & Clerk LLP

(57) **Abstract**

A three-dimensional semiconductor memory device may include a transistor array including a plurality of transistors on a substrate, a first guard contact plug extended into a region between the transistors, second guard contact plugs disposed to enclose the transistor array, and an impurity region below the first guard contact plug. The transistors may include a pair of first transistors, which are adjacent to each other with the first guard contact plug interposed therebetween, and a pair of second transistors, which are adjacent to the pair of first transistors. A distance between the pair of second transistors may be smaller than a distance between the pair of first transistors.

## Description

### BACKGROUND OF THE INVENTION

The present disclosure relates to a three-dimensional semiconductor memory device and an electronic system including the same.

Higher integration of semiconductor devices are desired to satisfy consumer demands for large data storing capacity, superior performance, and inexpensive prices. As such, semiconductor devices configured to store a large amount of data are desired as data storage for electronic systems. In the case of two-dimensional or planar semiconductor devices, since their integration is mainly determined by the area occupied by a unit memory cell, integration is greatly influenced by the level of a fine pattern forming technology. However, the extremely expensive process equipment needed to increase pattern fineness sets a practical limitation on increasing integration for two-dimensional or planar semiconductor devices. Thus, three-dimensional semiconductor memory devices including three-dimensionally arranged memory cells have recently been proposed.

### SUMMARY

At least one embodiment of the inventive concepts provides a three-dimensional semiconductor memory device with improved electrical characteristics and an electronic system including the same.

At least one embodiment of the inventive concepts provides a three-dimensional semiconductor memory device with an increased integration density and an electronic system including the same.

According to at least one embodiment of the inventive concepts, a three-dimensional semiconductor memory device may include a transistor array on a substrate, the transistor array including a plurality of transistors, a first guard contact plug vertically extended into a region between the plurality of transistors, second guard contact plugs enclosing the transistor array, and an impurity region below the first guard contact plug. The plurality of transistors may include a pair of first transistors and a pair of second transistors; the pair of first transistors adjacent to each other with the first guard contact plug interposed therebetween, and the pair of second transistors adjacent to the pair of first transistors in a second horizontal direction different from the first horizontal direction. A distance between the pair of second transistors may be smaller than a distance between the pair of first transistors.

According to at least one embodiment of the inventive concepts, a three-dimensional semiconductor memory device may include a transistor array on a substrate, the transistor array including a plurality of transistors; a first guard contact plug vertically extended into a region between the plurality of transistors; second guard contact plugs enclosing the transistor array; and an impurity region below the first guard contact plug.. The plurality of transistors may include a first transistor adjacent to the first guard contact plug and a second transistor adjacent to the first transistor in a first horizontal direction. In the first horizontal direction in which the first guard contact plug and the first transistor are adjacent to each other, a width of the second transistor may be larger than a width of the first transistor.

According to at least one embodiment of the inventive concepts, an electronic system may include a three-dimensional semiconductor memory device, and a controller electrically connected to the three-dimensional semiconductor memory device through an input/output pad, the controller configured to control the three-dimensional semiconductor memory device. The three-dimensional semiconductor memory device may include a peripheral circuit structure on a substrate, a cell array structure including a plurality of memory blocks, on the substrate, a transistor array in the peripheral circuit structure and on the substrate, the transistor array including a plurality of transistors, a first guard contact plug vertically extending into a region between the transistors, second guard contact plugs enclosing the transistor array, and an impurity region below the first guard contact plug. The transistors may include a pair of first transistors and a pair of second transistors, the pair first transistors adjacent to each other with the first guard contact plug interposed therebetween, and the pair of second transistors adjacent to the pair of first transistors. A distance between the pair of second transistors may be smaller than a distance between the pair of first transistors.

According to at least one embodiment of the inventive concepts, a three-dimensional semiconductor memory device may include a transistor array on a substrate, the transistor array including plurality of transistors, a device isolation pattern on the substrate and enclosing the plurality of transistors, a guard contact plug vertically extending in a region between the plurality of transistors to penetrate the device isolation pattern, and an impurity region below the guard contact plug.

The pair of first transistors may be closer to the first guard contact plug than any one of or each of the second guard contact plugs in a first and/or second direction. In use, resistance between the first transistors and the first guard contact plug may be reduced when compared with resistance between the first transistors and the any one of or each of the second guard contact plugs. This may improve the electrical characteristics of the device.

At least some of the above and other features of the disclosure are set out in the claims.

### BRIEF DESCRIPTION OF THE DRAWINGS

FIG. 1A is a schematic diagram illustrating an electronic system including a three-dimensional semiconductor memory device according to at least one embodiment of the inventive concepts.
FIG. 1B is a perspective view schematically illustrating an electronic system including a three-dimensional semiconductor memory device according to at least one embodiment of the inventive concepts.
FIGS. 1C and 1D are sectional views of semiconductor packages, each of which is taken along a line I-I' of FIG. 1B and includes a three-dimensional semiconductor memory device according to at least one embodiment of the inventive concepts.
FIG. 2A is a perspective view schematically illustrating a three-dimensional semiconductor memory device according to at least one embodiment of the inventive concepts.
FIG. 2B is a perspective view schematically illustrating a three-dimensional semiconductor memory device according to at least one embodiment of the inventive concepts.
FIG. 3 is a plan view illustrating a three-dimensional semiconductor memory device according to at least one embodiment of the inventive concepts.
FIGS. 4A and 4B are sectional views taken along lines A-A' and B-B' of FIG. 3, respectively.
FIG. 5 is a plan view illustrating a three-dimensional semiconductor memory device according to at least one embodiment of the inventive concepts.
FIG. 6 is a sectional view taken along a line A-A' of FIG. 5.
FIGS. 7A and 7B are plan views, each of which illustrates a three-dimensional semiconductor memory device according to at least one embodiment of the inventive concepts.
FIGS. 8A and 8B are plan views, each of which illustrates a three-dimensional semiconductor memory device according to at least one embodiment of the inventive concepts.
FIGS. 9A and 9B are plan views, each of which illustrates a three-dimensional semiconductor memory device according to at least one embodiment of the inventive concepts.
FIG. 10 is a plan view illustrating a three-dimensional semiconductor memory device according to at least one embodiment of the inventive concepts.
FIG. 11 is a plan view illustrating a three-dimensional semiconductor memory device according to at least one embodiment of the inventive concepts.
FIG. 12 is a plan view illustrating a three-dimensional semiconductor memory device according to at least one embodiment of the inventive concepts.

### DETAILED DESCRIPTION

Example embodiments of the inventive concepts will now be described more fully with reference to the accompanying drawings, in which example embodiments are shown. It will be understood that although terms such as "first" and "second" may be used herein to describe various components, these components should not be limited by these terms. These terms are only used to distinguish one element from another. Furthermore, it will be understood that when a material layer is referred to as being "on" or "above" a substrate or another layer, it can be directly on the substrate or the other layer, or intervening layers may also be present. It will also be understood that such spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly. Additionally, in the present specification, each of the expressions of "A or B", "at least one of A and B", "at least one of A or B", "A, B, or C", "at least one of A, B, and C", and "at least one of A, B, or C" may be used to represent one of the elements enumerated in the expression or any possible combination of the enumerated elements.

In the disclosure, terms such as "device", "element" or "unit" may be used to denote a unit that has at least one function or operation and is implemented with processing circuitry, such as hardware, software, or a combination of hardware and software. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc., and/or electronic circuits including said components.

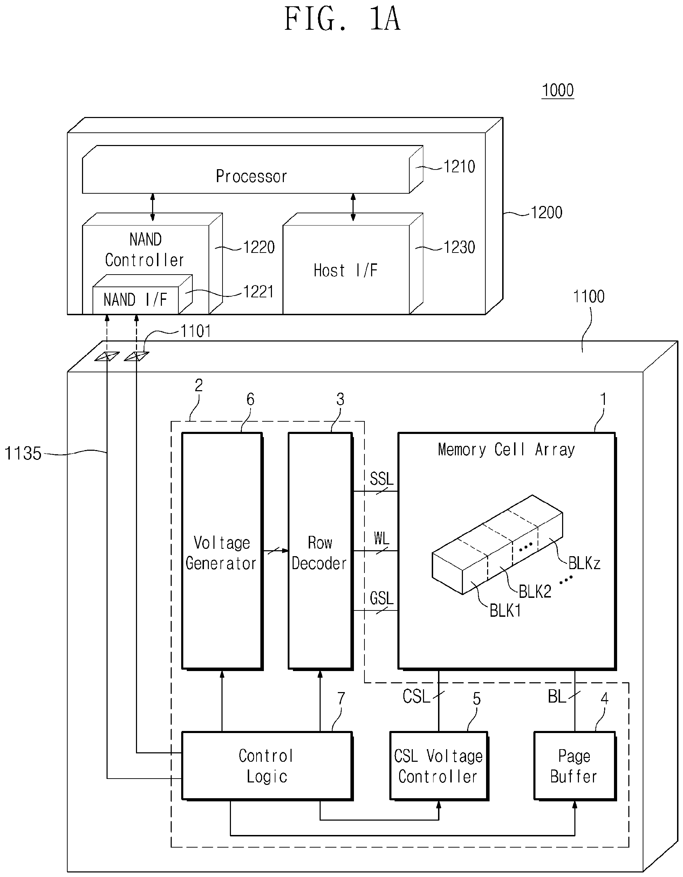

FIG. 1A is a schematic diagram illustrating an electronic system including a three-dimensional semiconductor memory device according to at least one embodiment of the inventive concepts.

Referring to FIG. 1A, an electronic system 1000 may include a three-dimensional semiconductor memory device 1100 and a controller 1200, which is electrically connected to the three-dimensional semiconductor memory device 1100. The electronic system 1000 may be a storage device including one or more three-dimensional semiconductor memory devices 1100 and/or an electronic device including the storage device. For example, the electronic system 1000 may be a solid state drive (SSD) device, a universal serial bus (USB), a computing system, a medical system, or a communication system, in which at least one three-dimensional semiconductor memory device 1100 is provided.

The three-dimensional semiconductor memory device 1100 may be a nonvolatile memory device (e.g., a NAND FLASH memory device).

The three-dimensional semiconductor memory device 1100 may include a memory cell array 1 and a peripheral circuit 2 controlling the memory cell array 1. The peripheral circuit 2 may include a row decoder 3, a page buffer 4, a common source line (CSL) voltage control circuit 5, a voltage generator 6, and control logics 7.

The memory cell array 1 may include a plurality of memory blocks BLK1 to BLKz. Each of the memory blocks BLK1 to BLKz may include a plurality of memory cells, which are three-dimensionally arranged. For example, each of the memory blocks BLK1 to BLKz may include structures that are stacked. Data may be read or written from or in one of the memory blocks BLK1 to BLKz that is selected in response to a block selection signal. An erase operation on the memory cells of the memory cell array 1 may be performed for each memory block.

In at least one embodiment, the three-dimensional semiconductor memory device 1100 may be a vertical-type NAND FLASH memory device. For the vertical-type NAND FLASH memory device, the memory blocks BLK1 to BLKz may include a plurality of cell strings that are configured to form a NAND structure.

The row decoder 3 may be configured to decode address information, which is input from the outside, to select at least one of the memory blocks BLK1 to BLKz based on the decoded address information, and to select word lines WL, a string selection line SSL, and a ground selection line GSL of the selected memory block. The row decoder 3 may be used to deliver a voltage, applied in a memory operation, to the word line WL of the selected memory block.

The page buffer 4 may be connected to the memory cell array 1 through the bit lines BL and may be configured to read out data stored in the memory cells.

The page buffer 4 may be used as a writing driver, which applies a voltage to the bit line BL depending on data to be stored in the memory cell array 1, in a programming operation, and may be used as a sensing amplifier, which senses data stored in the memory cell array 1, in a reading operation. The page buffer 4 may be operated in response to control signals provided from the control logic 7.

The CSL voltage control circuit 5 may be connected to the memory cell array 1 through a common source line CSL. The CSL voltage control circuit 5 may be configured to apply a common source voltage (e.g., a power or ground voltage) to the common source line CSL, under the control of the control logic 7.

The voltage generator 6 may be configured to generate voltages (e.g., program, read, erase, pass, and verify voltages), which are applied to internal operations of the memory cell array 1, under the control of the control logic 7.

The control logic 7 may be configured to generate various control signals, which will be used in a programming, reading, or erasing operation on the memory cell array 1, based on command, address, and control signals.

The three-dimensional semiconductor memory device 1100 may communicate with the controller 1200 through an input/output (I/O) pad 1101, which is electrically connected to the control logics 7. The I/O pad 1101 may be electrically connected to a logic circuit 1130 through an I/O connection line 1135.

The controller 1200 may include a processor 1210, a NAND controller 1220, and a host interface 1230. In at least one embodiment, the electronic system 1000 may include a plurality of three-dimensional semiconductor memory devices 1100, which are controlled by the controller 1200.

The processor 1210 may control overall operations of the electronic system 1000 including the controller 1200. Based on a specific firmware, the processor 1210 may execute operations of controlling the NAND controller 1220 and accessing the three-dimensional semiconductor memory device 1100. The NAND controller 1220 may include a NAND interface 1221, which is used for communication with the three-dimensional semiconductor memory device 1100. The NAND interface 1221 may be used to transmit or receive control commands, which are used to control the three-dimensional semiconductor memory device 1100, and data, which are written in or read from the memory cells of the three-dimensional semiconductor memory device 1100. The host interface 1230 may be configured to allow for communication between the electronic system 1000 and an external host. If a control command is provided from an external host through the host interface 1230, the processor 1210 may control the three-dimensional semiconductor memory device 1100 in response to the control command.

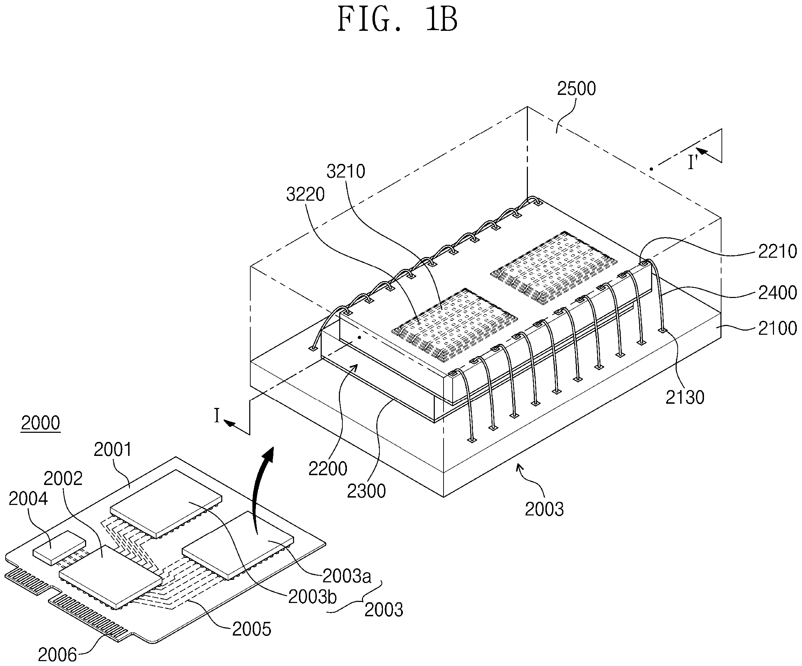

FIG. 1B is a perspective view schematically illustrating an electronic system including a three-dimensional semiconductor memory device according to at least one embodiment of the inventive concepts.

Referring to FIG. 1B, an electronic system 2000 according to at least one embodiment of the inventive concepts may include a main substrate 2001 and may further include a controller 2002, at least one semiconductor package 2003, and a DRAM 2004, which are mounted on the main substrate 2001. The semiconductor package 2003 and the DRAM 2004 may be connected to the controller 2002 and to each other by interconnection patterns 2005, which are formed in the main substrate 2001.

The main substrate 2001 may include a connector 2006, which includes a plurality of pins coupled to an external host. In the connector 2006, the number and arrangement of the pins may depend on a communication interface between the electronic system 2000 and the external host. In at least one embodiment, the electronic system 2000 may be configured to communicate with the external host, in accordance with one of interfaces, such as universal serial bus (USB), peripheral component interconnect express (PCI-Express), serial advanced technology attachment (SATA), universal flash storage (UFS) M-Phy, or the like. In at least one embodiment, the electronic system 2000 may be driven by a power, which is supplied from the external host through the connector 2006. The electronic system 2000 may further include a power management integrated circuit (PMIC), which is configured to distribute the power, which is supplied from the external host, to the controller 2002 and the semiconductor package 2003.

The controller 2002 may be configured to control a writing or reading operation on the semiconductor package 2003 and to improve an operation speed of the electronic system 2000.

The DRAM 2004 may be a buffer memory that is configured to relieve technical difficulties caused by a difference in speed between the semiconductor package 2003, which serves as a data storage device, and an external host. In at least one embodiment, the DRAM 2004 in the electronic system 2000 may serve as a cache memory and may be used as a storage space, which is used to temporarily store data during a control operation on the semiconductor package 2003. In the case where the electronic system 2000 includes the DRAM 2004, the controller 2002 may further include a DRAM controller for controlling the DRAM 2004, in addition to a NAND controller for controlling the semiconductor package 2003.

The semiconductor package 2003 may include first and second semiconductor packages 2003a and 2003b, which are spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed at respective bottom surfaces of the semiconductor chips 2200, a connection structure 2400 electrically connecting the semiconductor chips 2200 to the package substrate 2100, and a molding layer 2500 provided on the package substrate 2100 to cover the semiconductor chips 2200 and the connection structure 2400.

The package substrate 2100 may be a printed circuit board including upper pads 2130. Each semiconductor chip 2200 may include an I/O pad 2210. The I/O pad 2210 may correspond to the I/O pad 1101 of FIG. 1B. Each of the semiconductor chips 2200 may include stacks 3210 and vertical structures 3220. Each of the semiconductor chips 2200 may include a three-dimensional semiconductor memory device, which will be described below.

In at least one embodiment, the connection structure 2400 may be bonding wires that are provided to electrically connect the I/O pads 2210 to the upper pads 2130. Thus, in each of the first and second semiconductor packages 2003a and 2003b, the semiconductor chips 2200 may be electrically connected to each other in a bonding wire manner and may be electrically connected to the upper pads 2130 of the package substrate 2100. In other embodiments, the semiconductor chips 2200 in each of the first and second semiconductor packages 2003a and 2003b may be electrically connected to each other by a connection structure including through silicon vias (TSVs), not by the connection structure 2400 provided in the form of bonding wires.

In at least one embodiment, the controller 2002 and the semiconductor chips 2200 may be included in a single package. For example, the controller 2002 and the semiconductor chips 2200 may be mounted on a separate interposer substrate, which is prepared regardless of the main substrate 2001, and may be connected to each other through interconnection lines, which are provided in the interposer substrate.

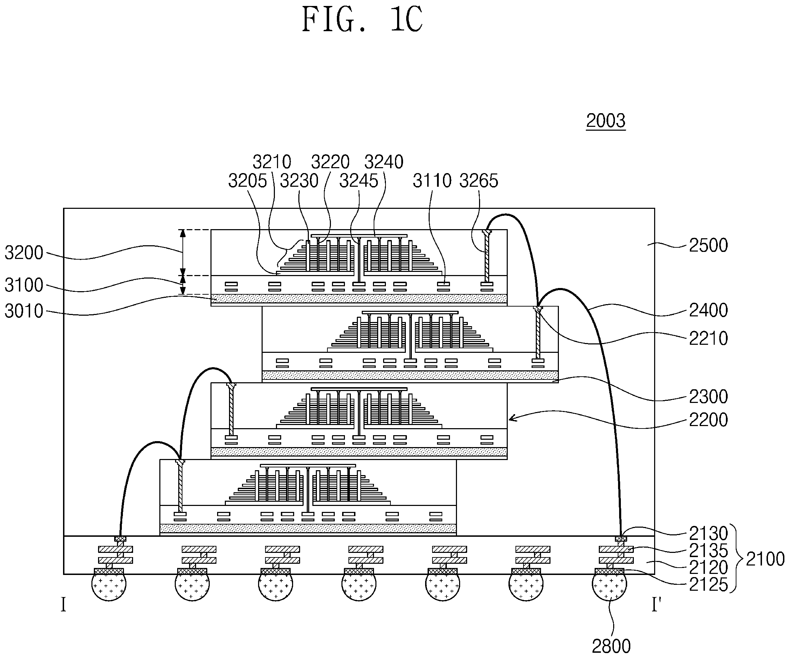

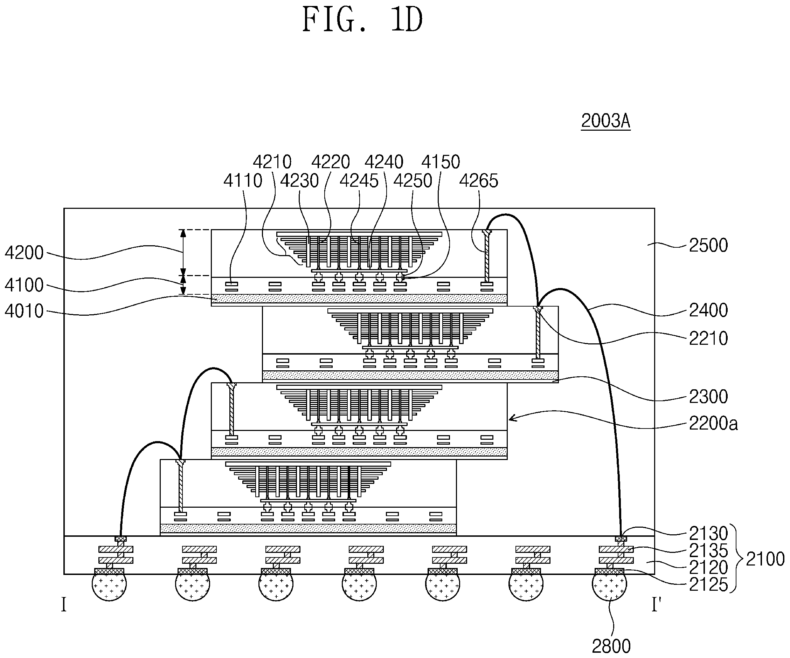

FIGS. 1C and 1D are sectional views of semiconductor packages, each of which is taken along a line I-I' of FIG. 1B and includes a three-dimensional semiconductor memory device according to at least one embodiment of the inventive concepts.

Referring to FIGS. 1C and 1D, the package substrate 2100 in the semiconductor package 2003 may be a printed circuit board. The package substrate 2100 may include a package substrate body portion 2120, upper pads 2130, which are disposed on a top surface of the package substrate body portion 2120, lower pads 2125, which are disposed on or exposed through a bottom surface of the package substrate body portion 2120, and internal lines 2135, which are disposed in the package substrate body portion 2120 to electrically connect the upper pads 2130 to the lower pads 2125. The upper pads 2130 may be electrically connected to the connection structures 2400. The lower pads 2125 may be connected to the interconnection patterns 2005 of the main substrate 2001 of the electronic system 2000 through conductive connecting portions 2800.

Referring to FIG. 1C, each of the semiconductor chips 2200 may include a semiconductor substrate 3010 and may further include a first structure 3100 and a second structure 3200, which are sequentially stacked on the semiconductor substrate 3010. The first structure 3100 may include a peripheral circuit region including peripheral lines 3110. The second structure 3200 may include a source structure 3205, a stack 3210 on the source structure 3205, the vertical structures 3220 and separation structures 3230 penetrating the stack 3210, bit lines 3240 electrically connected to the vertical structures 3220, and cell contact plugs 3235 electrically connected to the word lines WL of the stack 3210.

The stack 3210 is illustrated to have a stepwise structure, but the inventive concepts are not limited to this example. For example, the plurality of layers in the stack 3210 may be provided to have the same length, and in this case, the stack 3210 may not have a stepwise structure.

Each of the semiconductor chips 2200 may include a penetration line 3245, which is electrically connected to the peripheral lines 3110 of the first structure 3100 and is extended into the second structure 3200. The penetration line 3245 may be disposed outside the stack 3210, and in at least one embodiment, the penetration line 3245 may be provided to further penetrate the stack 3210. Each of the semiconductor chips 2200 may further include the I/O pad 2210 (e.g., of FIG. 1B), which is electrically connected to the peripheral lines 3110 of the first structure 3100.

Referring to FIG. 1D, each of the semiconductor chips 2200a in the semiconductor package 2003A may include a semiconductor substrate 4010, a first structure 4100 on the semiconductor substrate 4010, and a second structure 4200, which is provided on the first structure 4100 and is bonded to the first structure 4100 through a wafer bonding process.

The first structure 4100 may include a peripheral circuit region including a peripheral line 4110 and first junction structures 4150. The second structure 4200 may include a source structure 4205, a stack 4210 between the source structure 4205 and the first structure 4100, vertical structures 4220 and a separation structure 4230 penetrating the stack 4210, and second junction structures 4250, which are electrically and respectively connected to the vertical structures 4220 and the word lines WL of the stack 4210. For example, the second junction structures 4250 may be electrically connected to the vertical structures 4220 and the word lines WL, respectively, through bit lines 4240 and cell contact plugs 4235, which are electrically connected to the vertical structures 4220 and the word lines, respectively. The first junction structures 4150 of the first structure 4100 and the second junction structures 4250 of the second structure 4200 may be in contact with and bonded to each other. In at least one embodiment, the bonding portion of the first and second junction structures 4150 and 4250 may be formed of copper (Cu).

The stack 4210 is illustrated to have a stepwise structure, but the inventive concepts are not limited to this example. For example, the plurality of layers in the stack 4210 may be provided to have the same length, and in this case, the stack 4210 may not have the stepwise structure.

Each of the semiconductor chips 2200a may further include the I/O pads 2210 (e.g., of FIG. 1B), which are electrically connected to the peripheral lines 4110 of the first structure 4100.

The semiconductor chips 2200 of FIG. 1C or the semiconductor chips 2200a of FIG. 1D may be electrically connected to each other by the connection structures 2400, which are provided in the form of bonding wires. However, in at least one embodiment, semiconductor chips, which are provided in the same semiconductor package as the semiconductor chips 2200 or 2200a of FIG. 1C or 1D, may be electrically connected to each other by a connection structure including the through-silicon vias (TSVs).

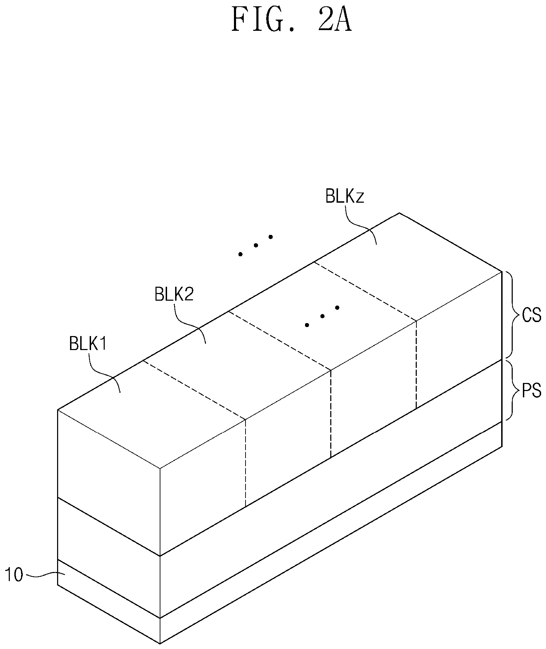

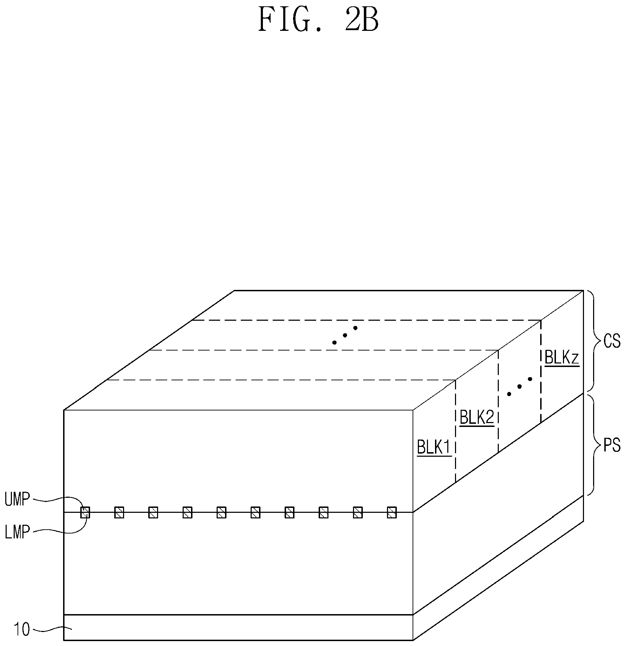

FIGS. 2A and 2B are perspective views schematically illustrating a three-dimensional semiconductor memory device according to at least one embodiment of the inventive concepts.

Referring to FIGS. 2A and 2B, the three-dimensional semiconductor memory device may include a substrate 10, a peripheral circuit structure PS on the substrate 10, and a cell array structure CS on the peripheral circuit structure PS.

The substrate 10 may be the semiconductor substrate 3010 described with reference to FIG. 1C and/or the semiconductor substrate 4010 described with reference to FIG. 1D. The peripheral circuit structure PS may be the first structure 3100 described with reference to FIG. 1C or the first structure 4100 described with reference to FIG. 1D. The cell array structure CS may be the second structure 3200 described with reference to FIG. 1C or the second structure 4200 described with reference to FIG. 1D.

The peripheral circuit structure PS may include the peripheral circuit 2 described with reference to FIG. 1A. The cell array structure CS may include a plurality of the memory blocks BLK1 to BLKz described with reference to FIG. 1A. In at least one embodiment, the peripheral circuit structure PS may be interposed between the substrate 10 and the cell array structure CS, but the inventive concepts are not limited to this example.

Referring to FIG. 2A, the peripheral circuit structure PS may be electrically connected to the cell array structure CS through the penetration line 3245 described with reference to FIG. 1C, although not illustrated in the drawings.

Referring to FIG. 2B, lower metal pads LMP may be provided in an upper portion of the peripheral circuit structure PS. The lower metal pads LMP may be the first junction structures 4150 described with reference to FIG. 1D. The lower metal pads LMP may be electrically connected to the peripheral circuit 2 of the peripheral circuit structure PS.

Upper metal pads UMP may be provided in a lower portion of the cell array structure CS. The upper metal pads UMP may be the second junction structures 4250 described with reference to FIG. 1D. The upper metal pads UMP may be electrically connected to the memory blocks BLK1 to BLKz in the cell array structure CS.

In at least one embodiment, the peripheral circuit structure PS on the substrate 10 and the cell array structure CS may be independently fabricated by separate processes. Next, the peripheral circuit structure PS and the cell array structure CS may be connected to each other through a bonding process. In detail, as a result of the bonding process, the lower metal pads LMP in the peripheral circuit structure PS may be in contact with the upper metal pads UMP in the cell array structure CS, respectively, and thus, the peripheral circuit structure PS may be electrically connected to the cell array structure CS.

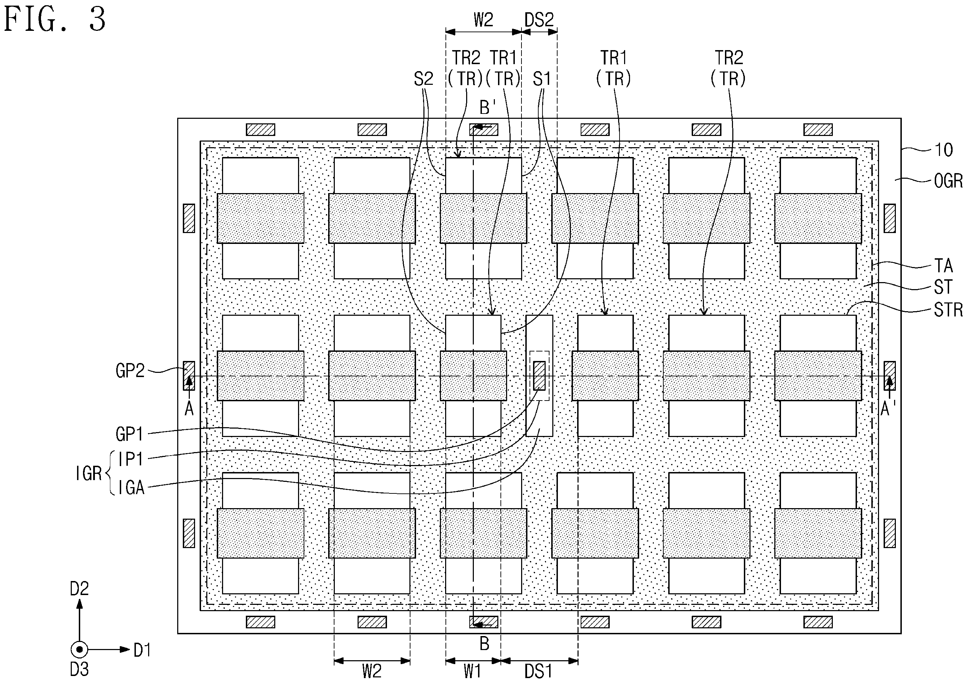

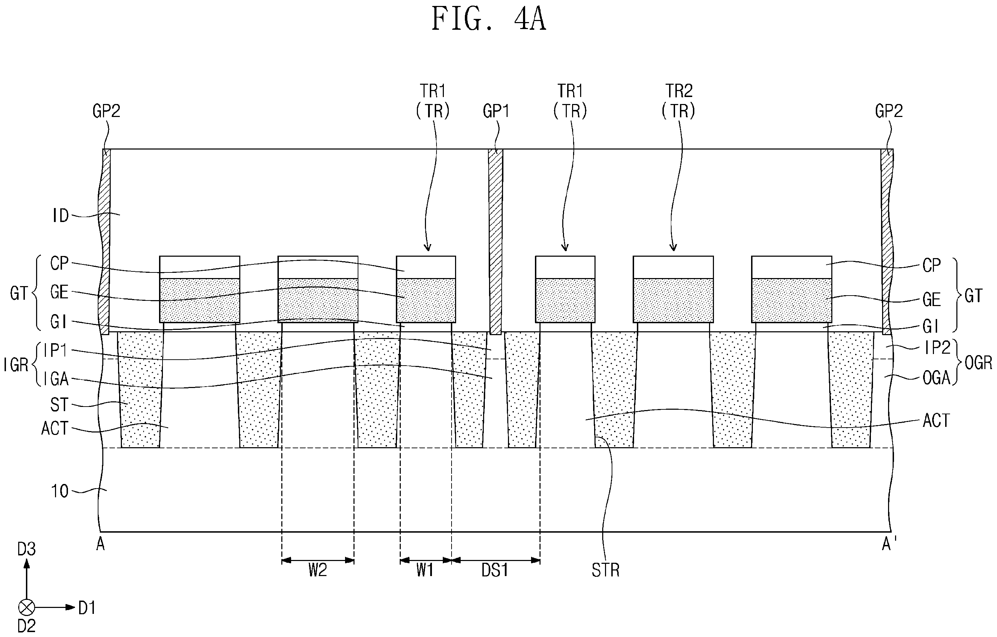

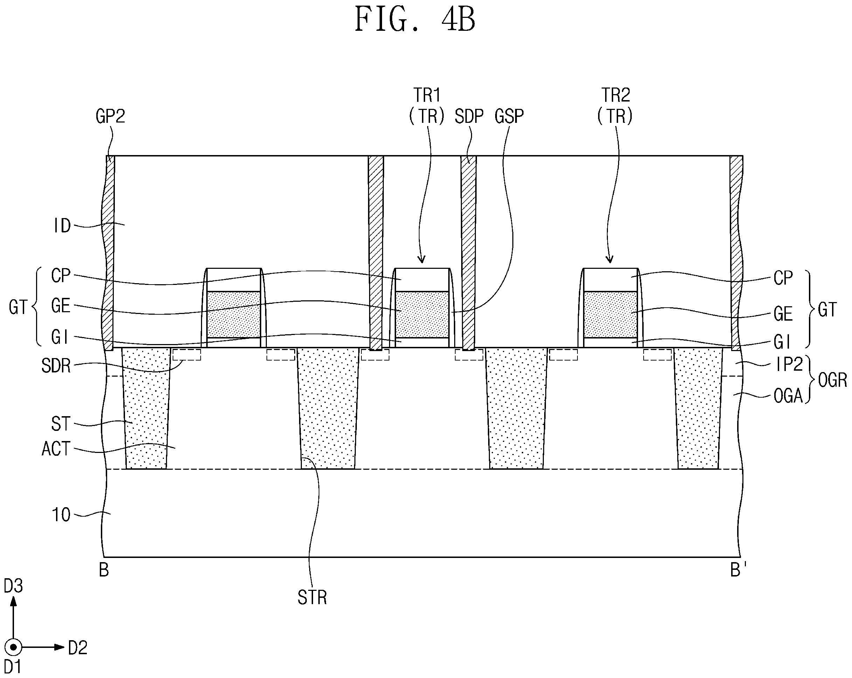

FIG. 3 is a plan view illustrating a three-dimensional semiconductor memory device according to at least one embodiment of the inventive concepts. FIGS. 4A and 4B are sectional views taken along lines A-A' and B-B' of FIG. 3, respectively.

Referring to FIGS. 3, 4A, and 4B, the three-dimensional semiconductor memory device may include the substrate 10. In at least one embodiment, the substrate 10 may be a silicon substrate, a silicon-germanium substrate, a germanium substrate, or a single crystalline epitaxial layer grown on a single crystalline silicon substrate. In at least one embodiment, the substrate 10 may include a well impurity layer (not shown) containing P-type and/or N-type impurities.

A transistor array TA may be provided on the substrate 10. The transistor array TA may include a plurality of transistors TR, which are disposed on the substrate 10 and are two-dimensionally arranged in a first direction D1 and a second direction D2. The first and second directions D1 and D2 may be parallel to the top surface of the substrate 10 and may not be parallel to each other. The first and second directions D1 and D2 may also be referred to as first and second horizontal directions D1 and D2. The arrangement of the transistors TR in the transistor array TA may be variously changed by those skilled in the art. The transistor array TA may be disposed on the substrate 10 in a third direction D3 (e.g., Z-axis). Each of the transistors TR may be disposed on the substrate 10 in the third direction D3. The transistor array TA and/or transistors TR may overlay the substrate 10 in the third direction D3. The third direction may be perpendicular to a top surface of the substrate 10. The third direction may be perpendicular to the first and second directions D1, D2.

Each of the transistors TR may include an active pattern ACT, a source/drain region SDR in the active pattern ACT, and a gate structure GT. A device isolation trench STR may be provided on the substrate 10 to define the active pattern ACT. A device isolation pattern ST may be provided to fill the device isolation trench STR. The active pattern ACT may include a portion of the substrate 10 enclosed by the device isolation pattern ST. In the present specification, the term "substrate 10" may refer to the remaining portion of the substrate 100, excluding the afore-described portions of the substrate 10, unless otherwise stated.

The active pattern ACT may be a bar-shaped pattern extended in the second direction D2, but the inventive concepts are not limited to this example. The shape of the active pattern ACT may be variously changed by those skilled in the art. In at least one embodiment, the active pattern ACT may have a short axis parallel to the first direction D1 and may have a long axis parallel to the second direction D2. The active pattern ACT may have a shape protruding in the third direction D3 that is perpendicular to the top surface of the substrate 10.

The source/drain region SDR may be provided in the active pattern ACT. The source/drain region SDR may be provided in an upper portion of the active pattern ACT, but the inventive concepts are not limited to this example. Alternatively, although not illustrated in the drawings, the source/drain region SDR may be provided on the active pattern ACT and may be formed on the active pattern ACT through a selective epitaxial growth (SEG) process. When viewed in a plan view, the source/drain region SDR may be provided at both sides of the gate structure GT. In at least some embodiments, the source/drain region SDR may contain P-type or N-type impurities.

The gate structure GT may include a gate electrode GE on the active pattern ACT, a gate insulating pattern GI between the gate electrode GE and the active pattern ACT, and a gate capping pattern CP on the gate electrode GE.

In at least one embodiment, the gate electrode GE may be formed of and/or include at least one of doped polysilicon, metallic materials, conductive metal nitride materials, conductive metal silicide materials, conductive metal oxide materials, and/or the like.

In at least one embodiment, the gate insulating pattern GI may be formed of or include at least one of silicon oxide, silicon oxynitride, high-k dielectric materials, and/or the like. In the present specification, the high-k dielectric material may be defined as a material having a dielectric constant higher than that of silicon oxide.

In at least one embodiment, the gate capping pattern CP may be formed of or include at least one of silicon oxide, silicon nitride, silicon oxynitride, low-k dielectric materials, and/or the like. In the present specification, the low-k dielectric material may be defined as a material having a dielectric constant lower than silicon oxide.

A source/drain plug SDP may be provided on the source/drain region SDR. The source/drain plug SDP may be in contact with the source/drain region SDR. In at least one embodiment, the source/drain plug SDP may be formed of and/or include at least one of conductive materials (e.g., metallic materials).

The transistor array TA may be provided in the peripheral circuit structure PS described with reference to FIGS. 2A and 2B. In detail, the transistor array TA may be provided in the peripheral circuit 2 described with reference to FIG. 1A. In at least one embodiment, the transistor array TA may be provided in at least one of the row decoder 3, the page buffer 4, the CSL voltage control circuit 5, the voltage generator 6, and/or the control logics 7.

The device isolation pattern ST may be provided to enclose the transistors TR. For example, the device isolation pattern ST may be provided to enclose and cover the active patterns ACT of the transistors TR. The device isolation pattern ST may be formed of or include at least one of insulating materials (e.g., silicon oxide (SiO₂), silicon nitride (SiN), etc.). The device isolation pattern ST may be a single layer, which is made of a single material, or a composite layer including two or more materials.

A gate spacer GSP may be provided on a side surface of the gate structure GT. In at least one embodiment, a plurality of gate spacers GSP may be provided. A pair of the gate spacers GSP may cover opposite side surfaces of the gate structure GT. The gate spacer GSP may be formed of or include an insulating material.

A peripheral circuit insulating layer ID may cover the transistor array TA. The peripheral circuit insulating layer ID may cover the gate structures GT of the transistors TR. In at least one embodiment, the peripheral circuit insulating layer ID may be formed of or include at least one of insulating materials. In at least one embodiment, the peripheral circuit insulating layer ID may be a single layer, which is made of a single material, or a composite layer including two or more materials.

An inner guard region IGR may be provided between a pair of the transistors TR, which are adjacent to each other in the first direction D1. The inner guard region IGR may include an inner guard active pattern IGA, which is provided on the substrate 10, and a first impurity region IP1, which is provided in an upper portion of the inner guard active pattern IGA.

The inner guard active pattern IGA may be configured to have the same and/or substantially similar features as the active pattern ACT. The inner guard active pattern IGA may be spaced apart from the active pattern ACT by the device isolation pattern ST. In at least one embodiment, when measured in the first direction D1, a width of the inner guard active pattern IGA may be smaller than a width of the active pattern ACT of each of the transistors TR. In at least one embodiment, when viewed in a plan view, the inner guard active pattern IGA may have an island shape. The inner guard active pattern IGA may be spaced apart from an outer guard region OGR, which will be described below. The first impurity region IP1 may contain P-type or N-type impurities. The first impurity region IP1 may contain impurities that are of a different conductivity type from the source/drain region SDR. The first impurity region IP1 may be provided below a first guard contact plug GP1, which will be described below.

The first guard contact plug GP1 may be provided on the inner guard region IGR. The first guard contact plug GP1 may be provided on the inner guard active pattern IGA. The first guard contact plug GP1 may be provided in the peripheral circuit insulating layer ID and may be extended into the first impurity region IP1. Due to the first impurity region IP1, a contact resistance property between the first guard contact plug GP1 and the inner guard active pattern IGA may be improved. In at least one embodiment, the first guard contact plug GP1 may be formed of or include one or more conductive materials (e.g., metallic materials).

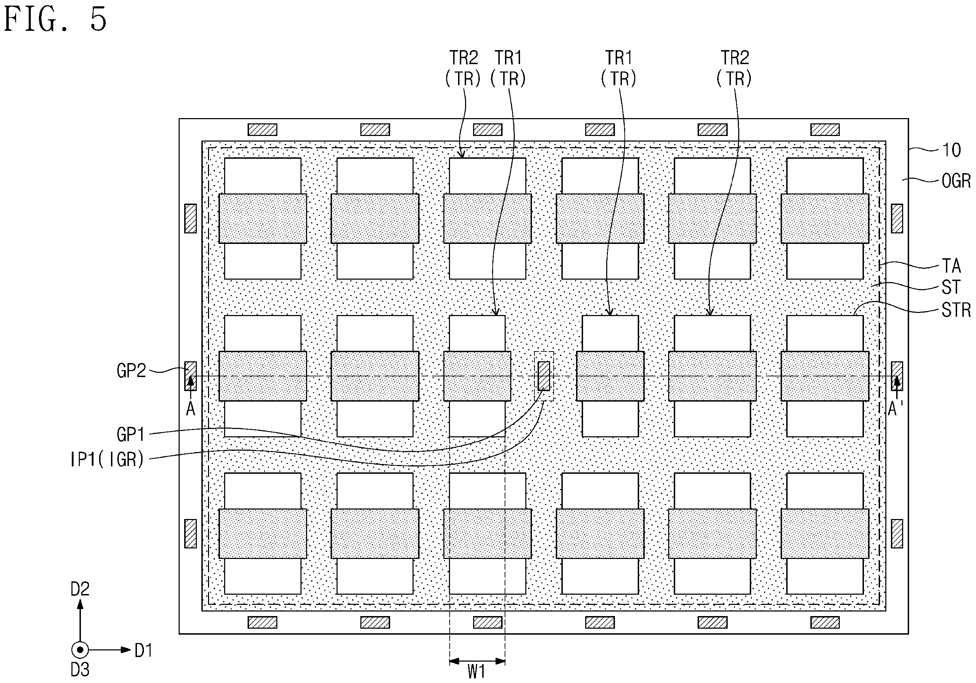

An example provided with a single inner guard region IGR is illustrated, but the inventive concepts are not limited to this example. In at least one embodiment, a plurality of inner guard regions IGR may be provided. Depending on the arrangement, position, number, shape, and characteristics of the transistors TR in the transistor array TA, the arrangement, position, number, and shape of the inner guard regions IGR may be variously changed by those skilled in the art. Other examples of the arrangement, position, number, and shape of the inner guard regions IGR will be described in more detail with reference to FIGS. 5 to 10.

The outer guard region OGR may be provided to enclose the transistor array TA. In at least one embodiment, the outer guard region OGR may have a closed loop shape, when viewed in a plan view. The outer guard region OGR may be spaced apart from the transistors TR and the inner guard region IGR. The outer guard region OGR may include an outer guard active pattern OGA, which is provided to enclose the transistor array TA, and second impurity regions IP2, which are provided in an upper portion of the outer guard active pattern OGA. The outer guard active pattern OGA may surround the transistor array TA in the first and/or directions D1, D2.

The outer guard active pattern OGA may be provided on the substrate 10. The outer guard active pattern OGA may overlay the substrate 10 in the third direction D3. The outer guard active pattern OGA may be defined by the device isolation pattern ST. The outer guard active pattern OGA may have a shape protruding from the substrate 10 in the third direction D3. In at least one embodiment, the outer guard active pattern OGA may have a closed loop shape, when viewed in a plan view. The second impurity region IP2 may contain P-type or N-type impurities. In at least one embodiment, the second impurity region IP2 may be doped to have the same conductivity type as the first impurity region IP1. The second impurity region IP2 may be doped to have a conductivity type different from the source/drain region SDR. The second impurity region IP2 may be provided below a second guard contact plug GP2, which will be described below.

The second guard contact plugs GP2 may be disposed to enclose the transistor array TA. The second guard contact plugs GP2 may surround the transistor array TA in the first and/or directions D1, D2. The second guard contact plugs GP2 may be provided on the outer guard region OGR. The second guard contact plugs GP2 may be provided on the outer guard active pattern OGA. Each of the second guard contact plugs GP2 may be provided in the peripheral circuit insulating layer ID and may be extended into a corresponding one of the second impurity regions IP2. Owing to the second impurity region IP2, a contact resistance property between the second guard contact plug GP2 and the outer guard active pattern OGA may be improved. In at least one embodiment, the second guard contact plug GP2 may include one or more conductive materials (e.g., metallic materials).

A well bias voltage may be applied to the inner guard region IGR through the first guard contact plug GP1. The well bias voltage may be applied to the outer guard region OGR through the second guard contact plug GP2. Depending on the property of the transistor TR in the transistor array TA (e.g., on whether the transistor is a n-type metal-oxide-semiconductor (NMOS) or a p-type MOS (PMOS) transistor), the well bias voltage may be a ground voltage or a voltage with a specific value.

According to at least one embodiment of the inventive concepts, the inner guard region IGR may be provided in the transistor array TA, and the first guard contact plug GP1 may be provided on the inner guard region IGR. Accordingly, the transistors TR, which are not adjacent to the outer guard region OGR, may be adjacent to the inner guard region IGR. In other words, a distance between the transistors TR, e.g., transistors TR which are not adjacent to the outer guard region OGR, and the inner guard region IGR may be smaller than a distance between the transistors TR and the outer guard region OGR. Since the inner guard region IGR is provided in the transistor array TA, a distance between the transistors TR and an element applied with the well bias voltage may be reduced, and thus the electric resistance between the transistors TR and the element applied with the well bias voltage may be reduced. Thus, the electrical characteristics of the three-dimensional semiconductor memory device may be improved.

The transistors TR may include a first transistor TR1 adjacent to the first guard contact plug GP1 and a second transistor TR2 adjacent to the outer guard region OGR. The second transistor TR2 may be adjacent to the first transistor TR1. In the present specification, the expression "one transistor TR is adjacent to one element" may be used to indicate that the one transistor TR and the one element are adjacent to each other without any other element (e.g., another transistor, a first guard contact plug, and so forth) therebetween.

The first transistor TR1 may be adjacent to the first guard contact plug GP1 in the first direction D1. The second transistor TR2 may be adjacent to the first transistor TR1 in a direction (e.g., the first direction D1) in which the first transistor TR1 and the first guard contact plug GP1 are adjacent to each other, or in a direction (e.g., the second direction D2) crossing the direction in which the first transistor TR1 and the first guard contact plug GP1 are adjacent to each other. The second transistor TR2 may be adjacent to the first guard contact plug GP1 in the first direction D1 with the first transistor TR1 interposed therebetween.

In a direction (e.g., the first direction D1) in which the first transistor TR1 and the first guard contact plug GP1 are adjacent to each other, a width W2 of the second transistor TR2 may be larger than a width W1 of the first transistor TR1. In the present specification, a width of the transistor TR may be defined as a width of a top surface of the active pattern ACT of the transistor TR. In other words, when measured in the first direction D1, the width W1 of the first transistor TR1 may be defined as a width of the top surface of the active pattern ACT of the first transistor TR1. Similarly, when measured in the first direction D1, the width W2 of the second transistor TR2 may be defined as a width of a top surface of the active pattern ACT of the second transistor TR2. In another embodiment, although not illustrated in the drawings, in the case where the source/drain region SDR is formed on the active pattern ACT through a SEG process, the width of the transistor TR may be defined as the largest width of the source/drain region SDR.

When measured at the same vertical level in a plan view, an area of the active pattern ACT of the second transistor TR2 may be larger than an area of the active pattern ACT of the first transistor TR1.

The active pattern ACT of each of the first and second transistors TR1 and TR2 may have a first side surface S1 facing the first direction D1 and a second side surface S2, which is opposite to the first side surface S 1. The first side surface S1 of the active pattern ACT of the first transistor TR1 may be a surface facing the first guard contact plug GP1. The first side surface S1 of the active pattern ACT of the first transistor TR1 may be closer to the first guard contact plug GP1 than the second side surface S2 of the active pattern ACT of the first transistor TR1. The second side surface S2 of the active pattern ACT of the second transistor TR2 may be aligned to the second side surface S2 of the active pattern ACT of the first transistor TR1. The first side surface S1 of the active pattern ACT of the second transistor TR2 may protrude relative to the first side surface S1 of the active pattern ACT of the first transistor TR1.

The first transistors TR1 may include a pair of the first transistors TR1, which are adjacent to each other with the first guard contact plug GP1 interposed therebetween. In at least one embodiment, the pair of the first transistors TR1 may be adjacent to each other in the first direction D1.

In at least one embodiment, a plurality of second transistors TR2 may be provided to enclose the pair of the first transistors TR1 and the inner guard region IGR. The plurality of second transistors TR2 may surround the pair of the first transistors TR1 and/or the inner guard region IGR in the first and/or second directions. The second transistors TR2 may be adjacent to each other in the first and/or second directions D1 and D2.

A pair of the second transistors TR2 may be adjacent to the pair of the first transistors TR1 in a direction (e.g., the second direction D2) that crosses a direction (e.g., the first direction D1) in which the pair of the first transistors TR1 are adjacent to each other. When measured at the same vertical level, a distance DS2 between the pair of the second transistors TR2 may be smaller than a distance DS1 between the pair of the first transistors TR1. In the present specification, a distance between a pair of the transistors TR may be defined as a distance from the active pattern ACT of one of the paired transistors TR to the active pattern ACT of the other of the paired transistors TR.

According to at least one embodiment of the inventive concepts, the inner guard region IGR may be provided between the pair of the first transistors TR1, but not between the pair of the second transistors TR2. Accordingly, in the direction in which the pair of the first transistors TR1 are adjacent to each other, the width W2 of the second transistor TR2 may be larger than the width W1 of the first transistor TR1. As a result, it is possible to reduce the area loss of the transistor TR, which occurs when the inner guard region IGR is provided. Thus, the integration density of the three-dimensional semiconductor memory device may be increased.

Hereinafter, various examples of the three-dimensional semiconductor memory device will be described in more detail with reference to FIGS. 5 to 13. For concise description, a previously described element may be identified by the same reference number and overlapping descriptions thereof may be omitted.

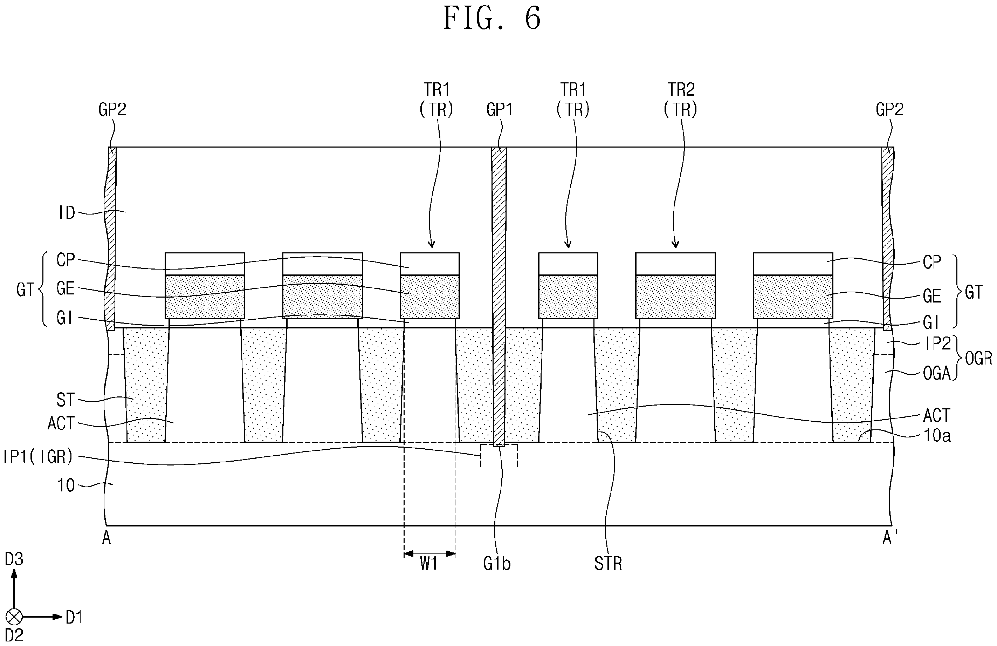

FIG. 5 is a plan view illustrating a three-dimensional semiconductor memory device according to at least one embodiment of the inventive concepts. FIG. 6 is a sectional view taken along a line A-A' of FIG. 5.

Referring to FIGS. 5 and 6, the inner guard active pattern IGA of the inner guard region IGR may be omitted. The first impurity region IP1 may be provided in an upper portion of the substrate 10 and may constitute the inner guard region IGR. The inner guard region IGR may be provided below the device isolation pattern ST. When viewed in a plan view, the inner guard region IGR may be interposed between a pair of the first transistors TR1, which are adjacent to each other in the first direction D1.

The first guard contact plug GP1 may be extended in the third direction D3 to pass through a region between the first transistors TR1. The first guard contact plug GP1 may penetrate the device isolation pattern ST in the third direction D3. The first guard contact plug GP1 may penetrate the device isolation pattern ST and may be extended into and in contact with the substrate 10. The first guard contact plug GP1 may penetrate the device isolation pattern ST and may be extended into the first impurity region IP1. A bottom surface G1b of the first guard contact plug GP1 may be located at a vertical level that is substantially equal to or lower than a top surface 10a of the substrate 10. The vertical level may be in third direction D3. The vertical level may be relative to a lowermost surface of the substrate.

According to at least one embodiment of the inventive concepts, the first guard contact plug GP1 may penetrate the device isolation pattern ST and may be extended into the inner guard region IGR, which is formed in an upper portion of the substrate 10. Accordingly, the first guard contact plug GP1 may be directly connected to the substrate 10, without the inner guard active pattern IGA described with reference to FIGS. 3, 4A, and 4B. As a result, an electric resistance between the first guard contact plug GP1 and the substrate 10 may be reduced, and the well bias voltage, which is applied through the first guard contact plug GP1, may be easily delivered to the substrate 10. Thus, the electrical characteristics of the three-dimensional semiconductor memory device may be improved.

In addition, since the first guard contact plug GP1 is directly connected to the substrate 10, the inner guard active pattern IGA described with reference to FIGS. 3, 4A, and 4B may not be provided. Accordingly, the width W1 of the first transistor TR1 may be larger than the width W1 of the first transistor TR1 described with reference to FIGS. 3, 4A, and 4B. As a result, the area of the first transistor TR1 may be increased, and the integration density of the three-dimensional semiconductor memory device may be improved.

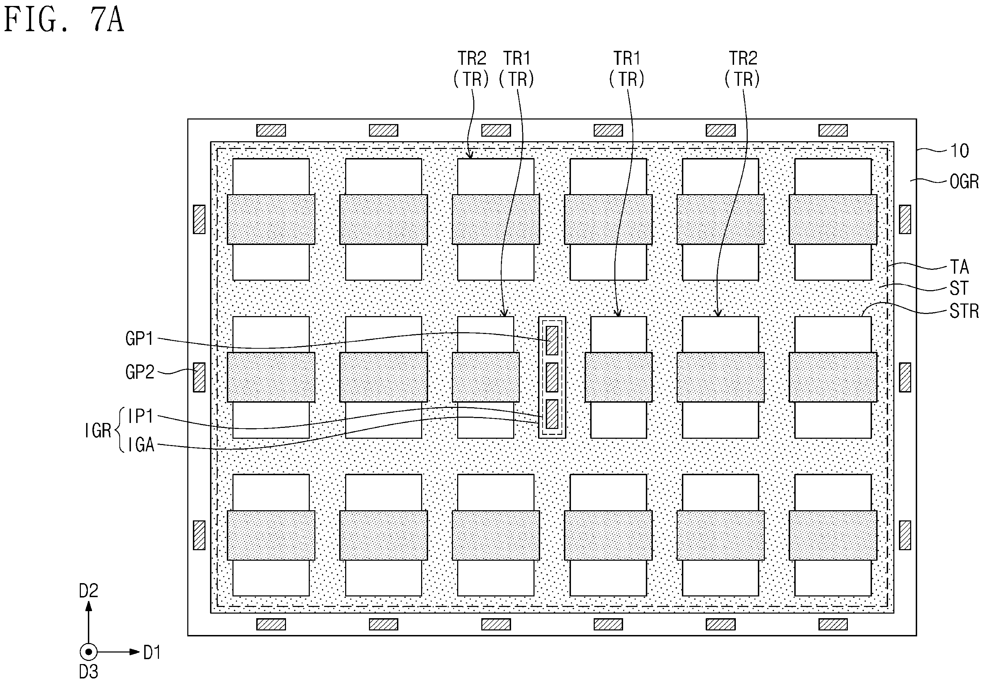

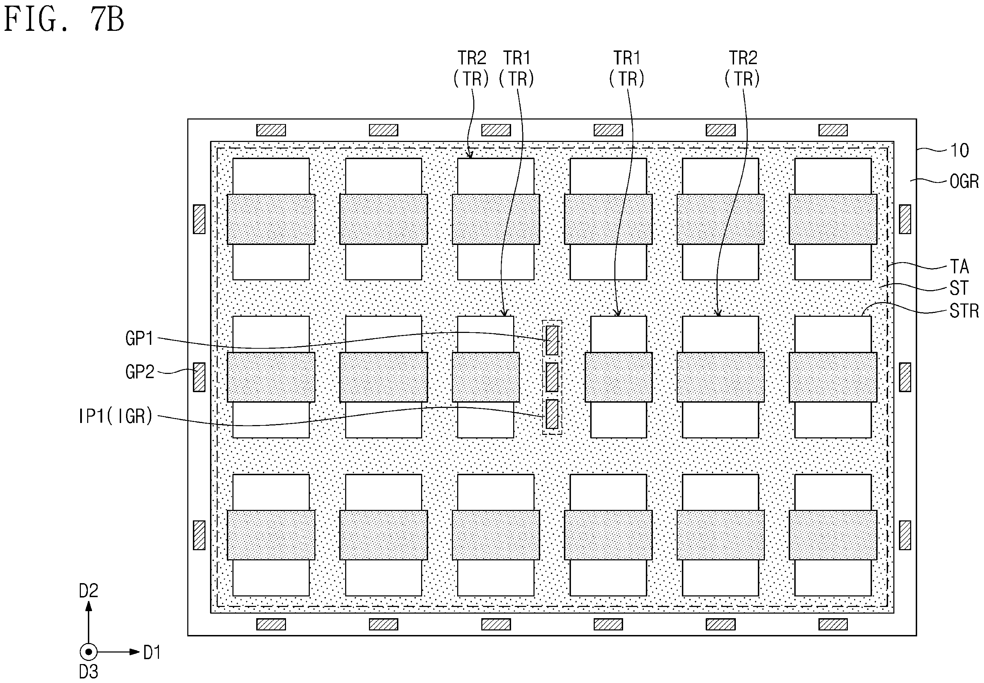

FIGS. 7A and 7B are plan views, each of which illustrates a three-dimensional semiconductor memory device according to at least one embodiment of the inventive concepts.

Referring to FIGS. 7A and 7B, the first guard contact plug GP1 may include a plurality of first guard contact plugs GP1 on the inner guard region IGR. Three first guard contact plugs GP1 are illustrated in FIGS. 7A and 7B, but the inventive concepts are not limited to this example; for example, two or more first guard contact plugs GP1 may be provided.

Since the first guard contact plugs GP1 are provided on the inner guard region IGR, it may be possible to sufficiently apply the well bias voltage to the substrate 10, when compared to the case where one first guard contact plug GP1 is provided. Thus, the electrical characteristics of the three-dimensional semiconductor memory device may be improved.

Referring to FIG. 7A, the first guard contact plugs GP1 may be provided on the inner guard active pattern IGA, as in FIGS. 3, 4A, and 4B. Referring to FIG. 7B, the first guard contact plugs GP1 may be provided on the inner guard region IGR, which is provided in an upper portion of the substrate 10, as in FIGS. 5 and 6.

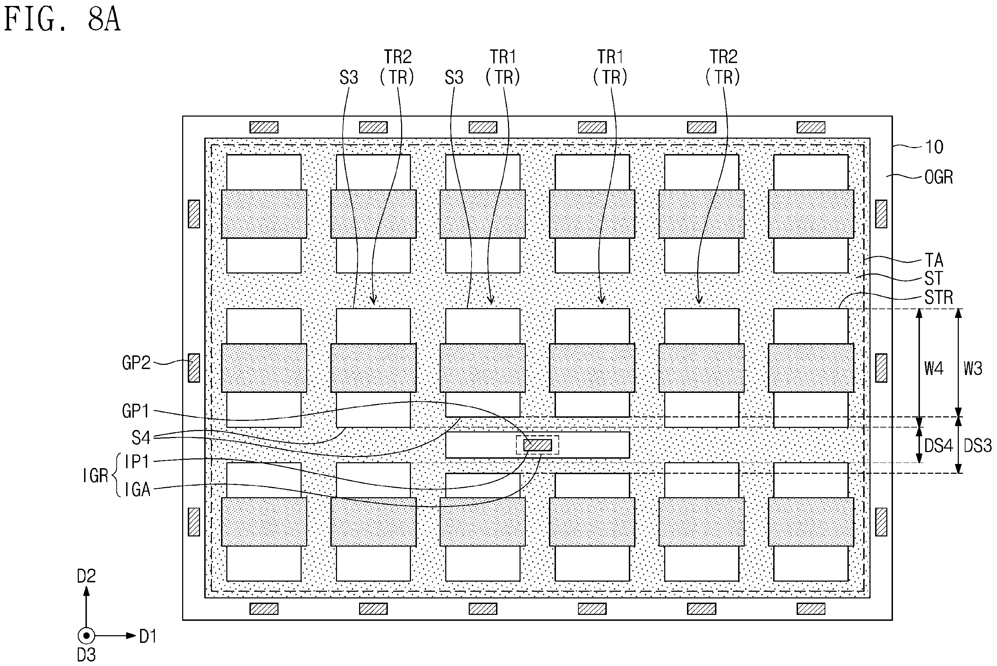

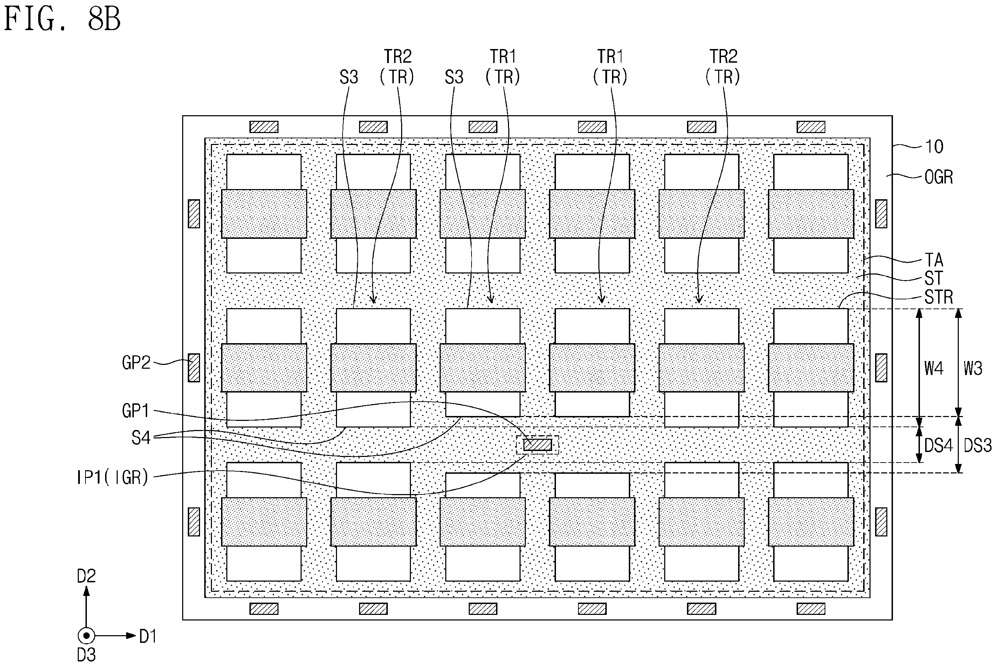

FIGS. 8A and 8B are plan views, each of which illustrates a three-dimensional semiconductor memory device according to at least one embodiment of the inventive concepts.

Referring to FIGS. 8A and 8B, the first transistor TR1 may be adjacent to the first guard contact plug GP1 in the second direction D2. The second transistor TR2 may be adjacent to the first transistor TR1 in a direction (e.g., the second direction D2) in which the first transistor TR1 and the first guard contact plug GP1 are adjacent to each other, or in a direction (e.g., the first direction D1) crossing the direction in which the first transistor TR1 and the first guard contact plug GP1 are adjacent to each other. The second transistor TR2 may be adjacent to the first guard contact plug GP1 in the second direction D2, and the first transistor TR1 may be interposed therebetween.

In the direction (e.g., the second direction D2) in which the first transistor TR1 and the first guard contact plug GP1 are adjacent to each other, a width W4 of the second transistor TR2 may be larger than a width W3 of the first transistor TR1.

The active pattern ACT of each of the first and second transistors TR1 and TR2 may have a third side surface S3 facing the second direction D2 which is normal and/or substantially normal to the second direction D2, and a fourth side surface S4, which is opposite to the third side surface S3. The fourth side surface S4 of the active pattern ACT of the first transistor TR1 may be a surface facing the first guard contact plug GP1. The fourth side surface S4 of the active pattern ACT of the first transistor TR1 may be closer to the first guard contact plug GP1 than the third side surface S3 of the active pattern ACT of the first transistor TR1. The third side surface S3 of the active pattern ACT of the second transistor TR2 may be aligned to the third side surface S3 of the active pattern ACT of the first transistor TR1. The fourth side surface S4 of the active pattern ACT of the second transistor TR2 may protrude relative to the fourth side surface S4 of the active pattern ACT of the first transistor TR1.

The first transistors TR1 may include a pair of the first transistors TR1, which are adjacent to each other with the first guard contact plug GP1 interposed therebetween. In at least one embodiment, the pair of the first transistors TR1 may be adjacent to each other in the second direction D2.

The pair of the first transistors TR1 may be adj acent to the pair of the second transistors TR2 in a direction (e.g., the first direction D1) crossing a direction (e.g., the second direction D2) in which the pair of the first transistors TR1 are adjacent to each other. When measured at the same vertical level, a distance DS4 between the pair of the second transistors TR2 may be smaller than a distance DS3 between the pair of the first transistors TR1.

Referring to FIG. 8A, the first guard contact plugs GP1 may be provided on the inner guard active pattern IGA, as shown in FIGS. 3, 4A, and 4B. The inner guard active pattern IGA may be extended in the first direction D1. In at least one embodiment, the active pattern ACT may have a short axis parallel to the second direction D2 and may have a long axis parallel to the first direction D1. Referring to FIG. 8B, the first guard contact plugs GP1 may be provided on the inner guard region IGR, which is provided in an upper portion of the substrate 10, as shown in FIGS. 5 and 6. Additionally, in at least some embodiments, a plurality of first guard contact plugs GP1 may be provided on the inner guard region IGR.

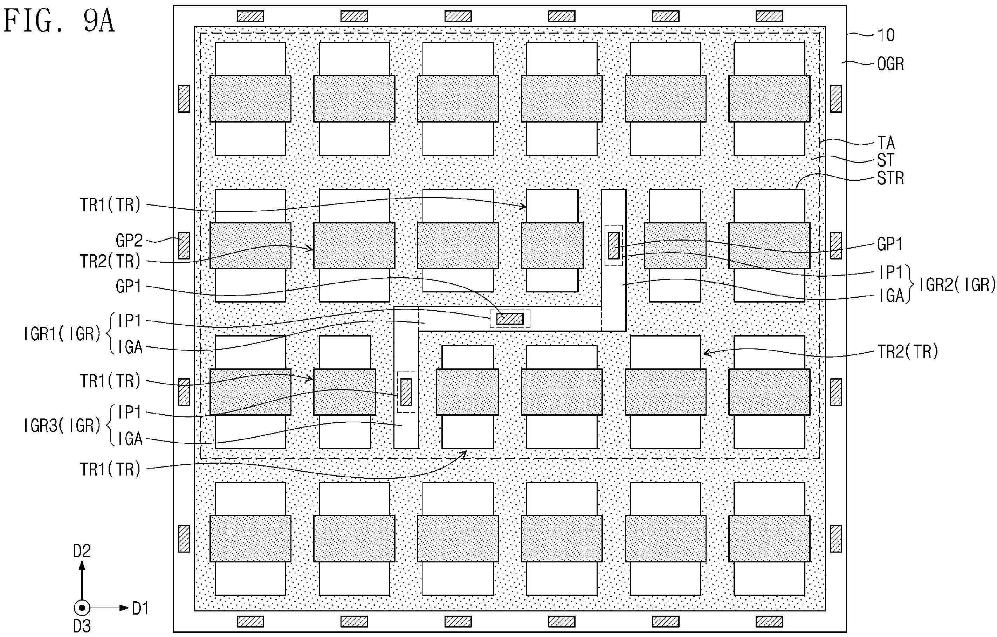

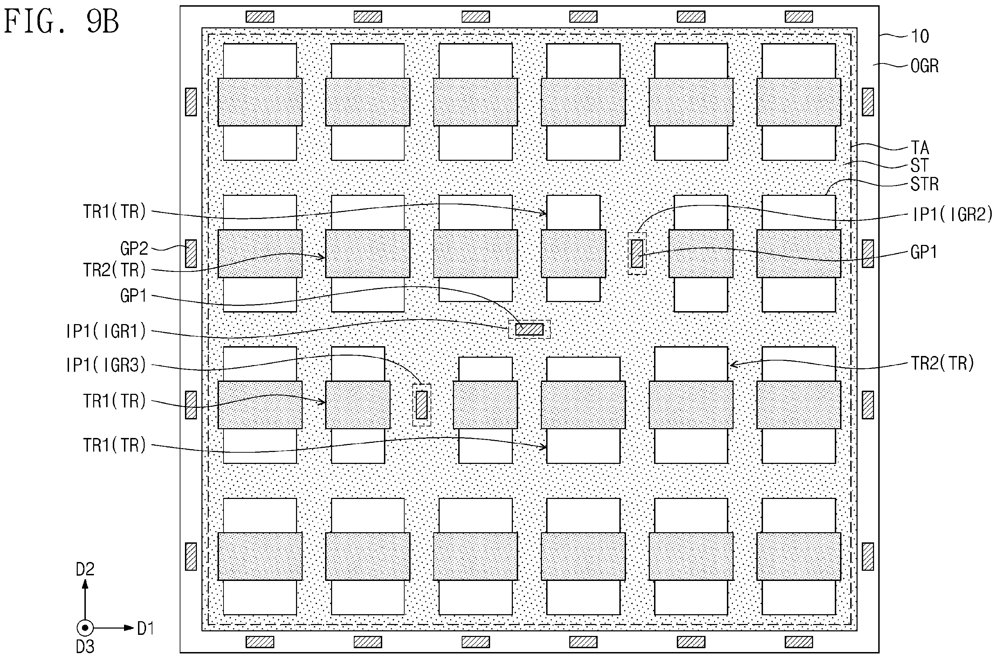

FIGS. 9A and 9B are plan views illustrating a three-dimensional semiconductor memory device according to at least one embodiment of the inventive concepts.

Referring to FIGS. 9A and 9B, the arrangement and number of the transistors TR in the transistor array TA may be different from those in the embodiment described with reference to FIGS. 3 to 6. Accordingly, the arrangement and shape of the inner guard region IGR may be different from those in the embodiment described with reference to FIGS. 3 to 6.

Referring to FIG. 9A, the inner guard region IGR may include a first inner guard region IGR1, which is extended from an intermediate region of the transistor array TA in the first direction D1, a second inner guard region IGR2, which is extended from an end of the first inner guard region IGR1 in the second direction D2, and a third inner guard region IGR3, which is extended from an opposite end of the first inner guard region IGR1 in an opposite direction of the second direction D2. The first to third inner guard regions IGR1, IGR2, and IGR3 may be connected to each other without an interface therebetween.

The first guard contact plugs GP1 may be provided on the first to third inner guard regions IGR1, IGR2, and IGR3, respectively. Each of the first guard contact plugs GP1 may be provided on the inner guard active pattern IGA of each of the first to third inner guard regions IGR1, IGR2, and IGR3.

Referring to FIG. 9B, the inner guard active pattern IGA of each of the first to third inner guard regions IGR1, IGR2, and IGR3 may not be provided, as shown in FIGS. 5 and 6. Each of the first guard contact plugs GP1 may be provided on the first impurity region IP1 of each of the first to third inner guard regions IGR1, IGR2, and IGR3, which are provided in an upper portion of the substrate 10, as shown in FIGS. 5 and 6.

Referring back to FIGS. 9A and 9B, since the first to third inner guard regions IGR1, IGR2, and IGR3 are provided to have the afore-described arrangement and shape, the transistors TR, which are not adjacent to the outer guard region OGR, may be adjacent to the first to third inner guard regions IGR1, IGR2, and IGR3. As a result, the well bias voltage may be easily delivered to the transistors TR, which are not adjacent to the outer guard region OGR, through the first to third inner guard regions IGR1, IGR2, and IGR3 and the first guard contact plugs GP1.

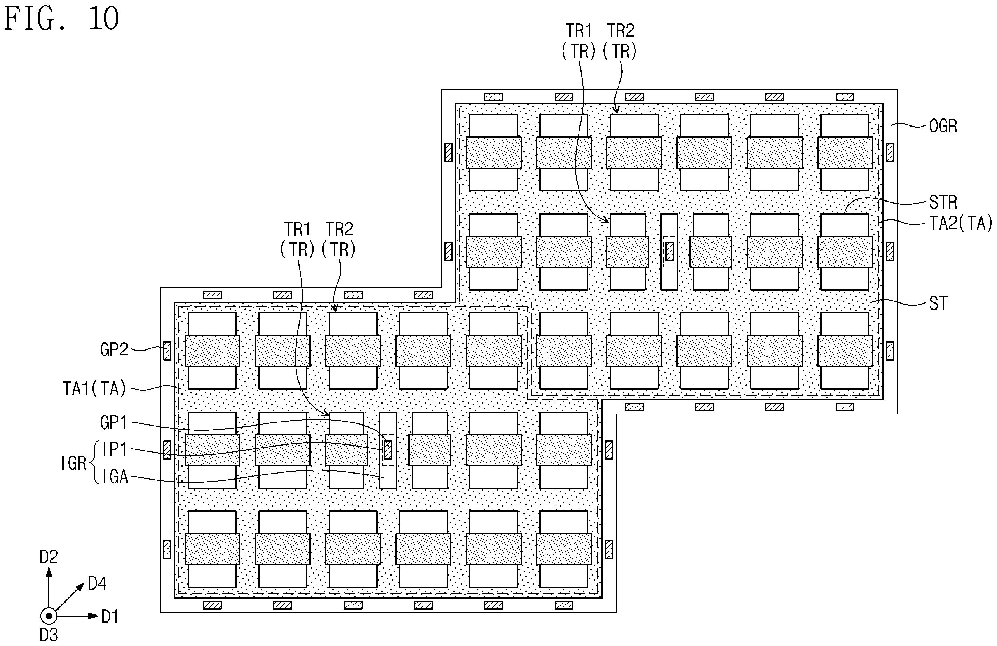

FIG. 10 is a plan view illustrating a three-dimensional semiconductor memory device according to at least one embodiment of the inventive concepts.

Referring to FIG. 10, the transistor array TA may include a first transistor array TA1 and a second transistor array TA2, which are adjacent to each other in a fourth direction D4. The fourth direction D4 may be parallel to the top surface of the substrate 10 and may not be parallel to the first and second directions D1 and D2.

The outer guard region OGR may be provided to enclose the first and second transistor arrays TA1 and TA2. In detail, the outer guard active pattern OGA of the outer guard region OGR may be provided to enclose the first and second transistor arrays TA1 and TA2.

The inner guard region IGR described with reference to FIGS. 3, 4A, and 4B may be provided in at least one of the first and second transistor arrays TA1 and TA2. The inner guard region IGR is illustrated to be provided in each of the first and second transistor arrays TA1 and TA2, but the inventive concepts are not limited to this example. The presence, number, arrangement, and shape of the inner guard region IGR in each of the first and second transistor arrays TA1 and TA2 may vary depending on the arrangement and number of the transistors TR in each of the first and second transistor arrays TA1 and TA2.

In addition, although the inner guard region IGR described with reference to FIGS. 3, 4A, and 4B is illustrated to be provided, the inventive concepts are not limited to this example. For example, the inner guard region IGR described with reference to FIGS. 5 and 6 may be provided below at least one of the first and second transistor arrays TA1 and TA2.

Two transistor arrays are illustrated, but the inventive concepts are not limited to this example. For example, three or more transistor arrays may be provided to be adjacent to each other in directions parallel to the top surface of the substrate 10.

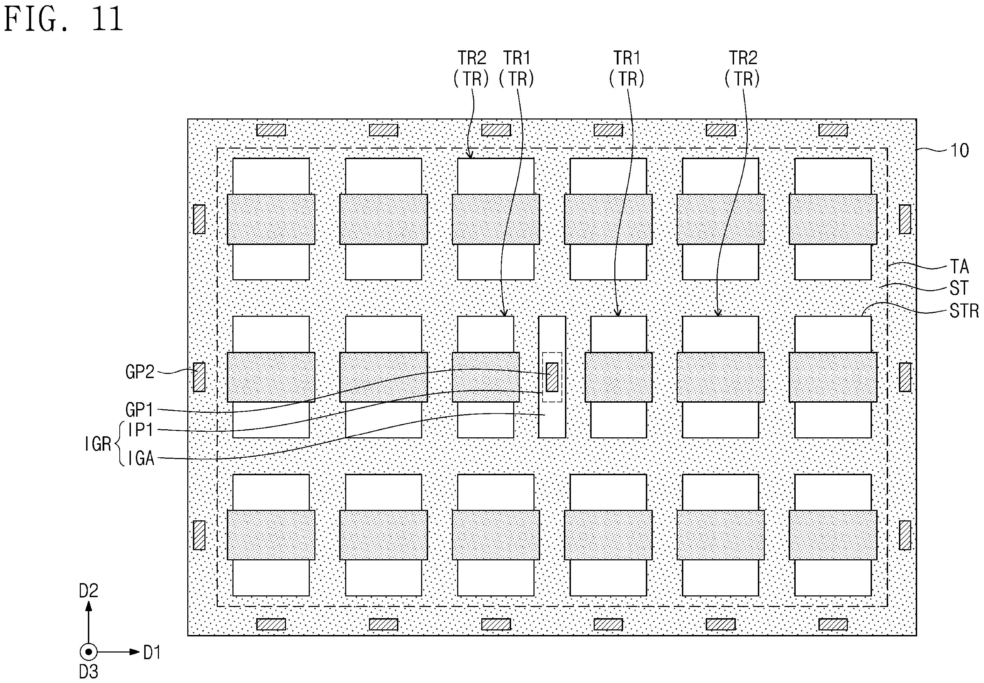

FIG. 11 is a plan view illustrating a three-dimensional semiconductor memory device according to at least one embodiment of the inventive concepts.

Referring to FIG. 11, the outer guard active pattern OGA described with reference to FIGS. 3, 4A, and 4B may not be provided. The second impurity region IP2 described with reference to FIGS. 3, 4A, and 4B may be provided in an upper portion of the substrate 10 and may constitute the outer guard region OGR.

The second guard contact plugs GP2 may be disposed to enclose the transistor array TA. For example, each of the second guard contact plugs GP2 may penetrate the device isolation pattern ST and may be extended into the second impurity region IP2. The second guard contact plug GP2 may be configured to have the same and/or substantially similar features as the first guard contact plug GP1 described with reference to FIGS. 5 and 6.

The inner guard region IGR and the first guard contact plug GP1 described with reference to FIGS. 3, 4A, and 4B are illustrated in the drawings, but the inventive concepts are not limited to this example. For example, the inner guard region IGR and the first guard contact plug GP1 described with reference to FIGS. 5 and 6, FIGS. 7A and 7B, FIGS. 8A and 8B, and/or 9A and 9B may be provided.

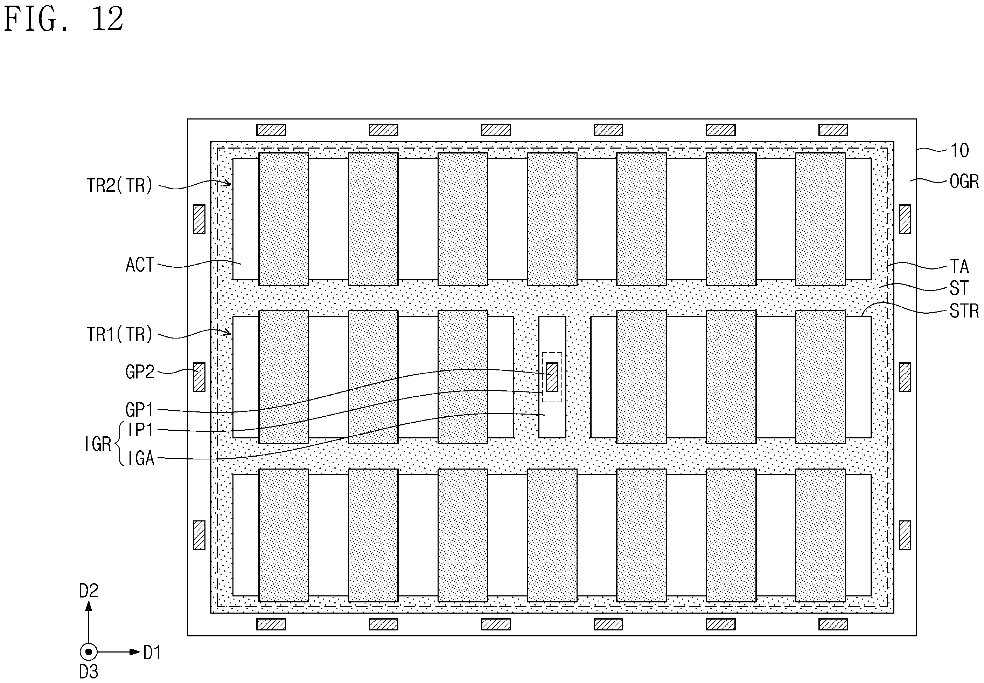

FIG. 12 is a plan view illustrating a three-dimensional semiconductor memory device according to at least one embodiment of the inventive concepts.

Referring to FIG. 12, each of the transistors TR may include one active pattern ACT that is extended in the first direction D1. In at least one embodiment, the active pattern ACT may have a short axis parallel to the second direction D2 and a long axis parallel to the first direction D1. Each of the transistors TR may include a plurality of gate structures GT, which are provided on the one active pattern ACT and are disposed in the first direction D1.

The first transistor TR1 may include the first transistors TR1, which are adjacent to each other in the first direction D1 with the first guard contact plug GP1 interposed therebetween. The second transistor TR2 may include the second transistors TR2, which are adjacent to each other in the second direction D2 with the first transistors TR1 interposed therebetween.

According to at least one embodiment of the inventive concepts, an inner guard region may be provided in a transistor array, and a first guard contact plug for applying a well bias voltage may be provided on the inner guard region. Accordingly, transistors, which are not adjacent to an outer guard region, may be adjacent to the inner guard region. Since the inner guard region is provided in the transistor array, a distance between each of the transistors and an element applied with the well bias voltage may be reduced, and this may make it possible to reduce an electric resistance between each of the transistors and the element applied with the well bias voltage. Thus, the electrical characteristics of the three-dimensional semiconductor memory device may be improved.

According to at least one embodiment of the inventive concepts, the inner guard region may be provided between a pair of first transistors, but not between a pair of second transistors. Accordingly, in a direction connecting (e.g., between) the pair of first transistors, the second transistor may be formed to have a width that is larger than that of the first transistor. As a result, it may be possible to reduce and/or minimize the area loss of a transistor, which occurs when the inner guard region is provided. Thus, the integration density of the three-dimensional semiconductor memory device may be increased.

While example embodiments of the inventive concepts have been particularly shown and described, it will be understood by one of ordinary skill in the art that variations in form and detail may be made therein without departing from the scope of the attached claims.

Embodiments are set out in the following clauses:
Clause 1: A three-dimensional semiconductor memory device, comprising:
   a transistor array on a substrate, the transistor array including a plurality of transistors;
   a first guard contact plug vertically extended into a region between the plurality of transistors;
   second guard contact plugs enclosing the transistor array; and
   an impurity region below the first guard contact plug,
   wherein the plurality of transistors comprise a pair of first transistors and a pair of second transistors,
   wherein the pair of first transistors are adjacent to each other in a first horizontal direction with the first guard contact plug interposed therebetween,
   wherein the pair of second transistors are adjacent to the pair of first transistors in a second horizontal direction different from the first horizontal direction, and
   wherein a distance between the pair of second transistors is smaller than a distance between the pair of first transistors.
Clause 2: The semiconductor memory device of clause 1, wherein, in the first horizontal direction, a width of each of the pair of second transistors is larger than a width of each of the pair of first transistors.
Clause 3: The semiconductor memory device of clause 1 or 2, wherein each of the pair of first transistors and the pair of second transistors comprises an active pattern, and
   wherein an area of the active pattern of each of the pair of second transistors is larger than an area of the active pattern of each of the pair of first transistors, when measured in a plan view at a same vertical level.
Clause 4: The semiconductor memory device of clause 1 or 2, wherein each of the pair of first transistors and the pair of second transistors comprises an active pattern,
   wherein the active pattern of each of the pair of first transistors has a first side surface adjacent to the first guard contact plug and a second side surface opposite to the first side surface,
   wherein a side surface of the active pattern of each of the pair of second transistors is aligned to the second side surface of the active pattern of each of the pair of first transistors, and
   wherein an opposite side surface of the active pattern of each of the pair of second transistors protrudes relative to the first side surface of the active pattern of each of the pair of first transistors.
Clause 5: The semiconductor memory device of any preceding clause, further comprising:
   an inner guard active pattern on the substrate,
   wherein the impurity region is provided in an upper portion of the inner guard active pattern, and
   wherein the first guard contact plug is extended into the impurity region.
Clause 6: The semiconductor memory device of any preceding clause, further comprising:
   a device isolation pattern on the substrate and at least partially enclosing the plurality of transistors,
   wherein the first guard contact plug penetrates the device isolation pattern.
Clause 7: The semiconductor memory device of any of clauses 1 to 4, wherein the impurity region is in an upper portion of the substrate, and
   wherein the first guard contact plug is extended into the impurity region.
Clause 8: The semiconductor memory device of any preceding clause, wherein a bottom surface of the first guard contact plug is at a vertical level that is substantially equal to or lower than a top surface of the substrate.
Clause 9: The semiconductor memory device of any preceding clause, wherein each of the pair of first transistors and the pair of second transistors comprises an active pattern and a source/drain region in the active pattern,
   wherein the impurity region and the source/drain region comprise impurities, and
   wherein the impurities of the impurity region are of a different conductivity type from the impurities of the source/drain region.
Clause 10: The semiconductor memory device of any preceding clause, further comprising:
   an outer guard active pattern enclosing the transistor array,
   wherein the second guard contact plugs are in contact with the outer guard active pattern.
Clause 11: The semiconductor memory device of any preceding clause, further comprising:
   a peripheral circuit structure on the substrate; and
   a cell array structure including a plurality of memory blocks, on the substrate, wherein the transistor array is provided in the peripheral circuit structure.

## Claims

1. A three-dimensional semiconductor memory device, comprising:
a transistor array on a substrate, the transistor array including a plurality of transistors;
a first guard contact plug vertically extended into a region between the plurality of transistors;
second guard contact plugs enclosing the transistor array; and
an impurity region below the first guard contact plug,
wherein the plurality of transistors comprise a pair of first transistors and a pair of second transistors,
wherein the pair of first transistors are adjacent to each other in a first horizontal direction with the first guard contact plug interposed therebetween,
wherein the pair of second transistors are adjacent to the pair of first transistors in a second horizontal direction different from the first horizontal direction, and
wherein a distance between the pair of second transistors is smaller than a distance between the pair of first transistors.

2. The semiconductor memory device of claim 1, wherein, in the first horizontal direction, a width of each of the pair of second transistors is larger than a width of each of the pair of first transistors.

3. The semiconductor memory device of claim 1 or 2, wherein each of the pair of first transistors and the pair of second transistors comprises an active pattern, and
wherein an area of the active pattern of each of the pair of second transistors is larger than an area of the active pattern of each of the pair of first transistors, when measured in a plan view at a same vertical level.

4. The semiconductor memory device of claim 1 or 2, wherein each of the pair of first transistors and the pair of second transistors comprises an active pattern,
wherein the active pattern of each of the pair of first transistors has a first side surface adjacent to the first guard contact plug and a second side surface opposite to the first side surface,
wherein a side surface of the active pattern of each of the pair of second transistors is aligned to the second side surface of the active pattern of each of the pair of first transistors, and
wherein an opposite side surface of the active pattern of each of the pair of second transistors protrudes relative to the first side surface of the active pattern of each of the pair of first transistors.

5. The semiconductor memory device of any preceding claim, further comprising:
an inner guard active pattern on the substrate,
wherein the impurity region is provided in an upper portion of the inner guard active pattern, and
wherein the first guard contact plug is extended into the impurity region.

6. The semiconductor memory device of claim 5, further comprising:
an inner guard region between the pair of first transistors, the inner guard region comprising the inner guard active pattern.

7. The semiconductor memory device of claim 6, wherein the inner guard region is only between the pair of first transistors.

8. The semiconductor memory device of any preceding claim, further comprising:
a device isolation pattern on the substrate and at least partially enclosing the plurality of transistors,
wherein the first guard contact plug penetrates the device isolation pattern.

9. The semiconductor memory device of claim 8, wherein the first guard contact plug is directly connected to the substrate.

10. The semiconductor memory device of any of claims 1 to 4, wherein the impurity region is in an upper portion of the substrate, and
wherein the first guard contact plug is extended into the impurity region.

11. The semiconductor memory device of any of claims 1 to 4, wherein a bottom surface of the first guard contact plug is at a vertical level that is substantially equal to or lower than a top surface of the substrate.

12. The semiconductor memory device of any preceding claim, wherein the semiconductor memory device comprises a plurality of first guard contact plugs vertically extending into a region between the plurality of transistors.

13. The semiconductor memory device of any preceding claim, wherein each of the pair of first transistors and the pair of second transistors comprises an active pattern and a source/drain region in the active pattern,
wherein the impurity region and the source/drain region comprise impurities, and
wherein the impurities of the impurity region are of a different conductivity type from the impurities of the source/drain region.

14. The semiconductor memory device of any preceding claim, further comprising:
an outer guard active pattern enclosing the transistor array,
wherein the second guard contact plugs are in contact with the outer guard active pattern.

15. The semiconductor memory device of any preceding claim, further comprising:
a peripheral circuit structure on the substrate; and
a cell array structure including a plurality of memory blocks, on the substrate,
wherein the transistor array is provided in the peripheral circuit structure.
